# EUROPEAN PATENT APPLICATION

(11) **EP 4 472 359 A1**
(43) Date of publication of application: **04.12.2024**
(21) Application number: 22922151.0
(22) Date of filing: 19.12.2022
(51) Int. Cl.: H05K 1/02, H05K 3/10

(54) **WIRING BOARD**

(30) Priority: 24.01.2022 JP 2022008416
(71) Applicant: Panasonic Intellectual Property Management Co., Ltd., Kadoma-shi, Osaka 571-0057 (JP)
(72) Inventor: ARAKI, Kota, Kadoma-shi, Osaka 571-0057 (JP); MURAOKA, Keishu, Kadoma-shi, Osaka 571-0057 (JP); NAGASHIMA, Susumu, Kadoma-shi, Osaka 571-0057 (JP)
(74) Representative: Grünecker Patent- und Rechtsanwälte PartG mbB
(86) International application number: PCT/JP2022/046668
(87) International publication number: WO 2023/140001

(57) **Abstract**

A wiring board (1) includes: a film (10) made of resin; a first insulating layer (20) including a first groove (21); a first wire (40) provided in the first groove (21); a second insulating layer (30) including a second groove (31) and an opening (32) that is located above the first wire (40); and a second wire (50) provided in the second groove (31) and the opening (32). The first groove (21) includes a first base face and first lateral faces. In the first base face and the first lateral faces, the first insulating layer is made of the same material. The second groove (31) includes a second base face and second lateral faces. In the second base face, the second lateral faces, and a lateral face of the opening (32), the second insulating layer (30) is made of the same material. A top face of the first wire (40) and a bottom face of the second wire (50) provided in the opening (32) are joined to each other.

## Description

### [Technical Field]

The present disclosure relates to wiring boards that include wires, and particularly relates to a wiring board in which wires are embedded in grooves of an insulating layer formed on a film.

### [Background Art]

Wiring boards that include wires are being utilized in electronic devices. Wiring boards are utilized as mounting boards on which electronic components such as circuit elements or light-emitting elements are mounted, or as touch sensor boards to which sensor electrodes are provided, or as connecting boards for electrically connecting electrical components. For example, display apparatuses in which light-emitting elements such as LEDs are arranged in a matrix on a wiring board are known as electronic devices that utilize a wiring board as a mounting board. Furthermore, touch panels in which sensor electrodes are arranged in a matrix on a wiring board are known as electronic devices that utilizes a wiring board as a touch sensor board (see Patent Literature (PTL) 1, for example).

In recent years, as a technique for forming fine wires, there is a technique of forming grooves in an insulating layer and embedding wires inside the grooves. As such a type of technique, the imprinting method, for example, is attracting attention. The imprinting method is a technique of forming grooves in an insulating layer by transferring a fine concave-convex structure onto a resin material using a mold that has a concave-convex structure, and forming fine wires inside the grooves.

### [Citation List]

### [Patent Literature]

[PTL 1] Japanese Patent No. 6706760

### [Summary of Invention]

### [Technical Problem]

However, in a wiring board in which a single insulating layer is formed, when many electronic components such as light-emitting elements or circuit elements are mounted on the wiring board and driven, a large proportion of the wiring board is occupied by wires when the wiring board is viewed from the top.

For example, in a case where a display apparatus is configured using a wiring board in which wires are embedded in grooves formed in a single insulating layer, in the wiring board, the insulating layer in which the wires are embedded is made of only a single layer, and thus, when wires are formed in a pattern for matrix-driving light-emitting elements arranged in a matrix, there are regions where many wires need to be formed between adjacent light-emitting elements. For this reason, when the wiring board is viewed from the top, a large proportion of the wiring board is occupied by wires. As a result, the interval between light-emitting elements cannot be reduced, and thus displaying a high-definition image is not possible.

The present disclosure is conceived in order to solve such a problem and has as an object to provide a wiring board that enables the proportion of the wiring board that is occupied by wires when viewed from the top, to be reduced.

### [Solution to Problem]

In order to achieve the above-described object, a wiring board according to an aspect of the present disclosure includes: a film made of resin; a first insulating layer located above the film and including a first groove; a first wire provided in the first groove, the first wire being conductive; a second insulating layer located above the first insulating layer and including a second groove and an opening, the opening being located above the first wire; and a second wire provided in the second groove and the opening, the second wire being conductive, wherein the first groove includes a first base face and first lateral faces that are continuously connected to the first base face, in the first base face and the first lateral faces, the first insulating layer is made of a same material, the second groove includes a second base face and second lateral faces that are continuously connected to the second base face, in the second base face, the second lateral faces, and a lateral face of the opening, the second insulating layer is made of a same material, and a top face of the first wire and a bottom face of the second wire that is provided in the opening are joined to each other.

### [Advantageous Effects of Invention]

It is possible to realize a wiring board that enables the proportion of the wiring board that is occupied by wires when viewed from the top, to be reduced.

### [Brief Description of Drawings]

[FIG. 1]

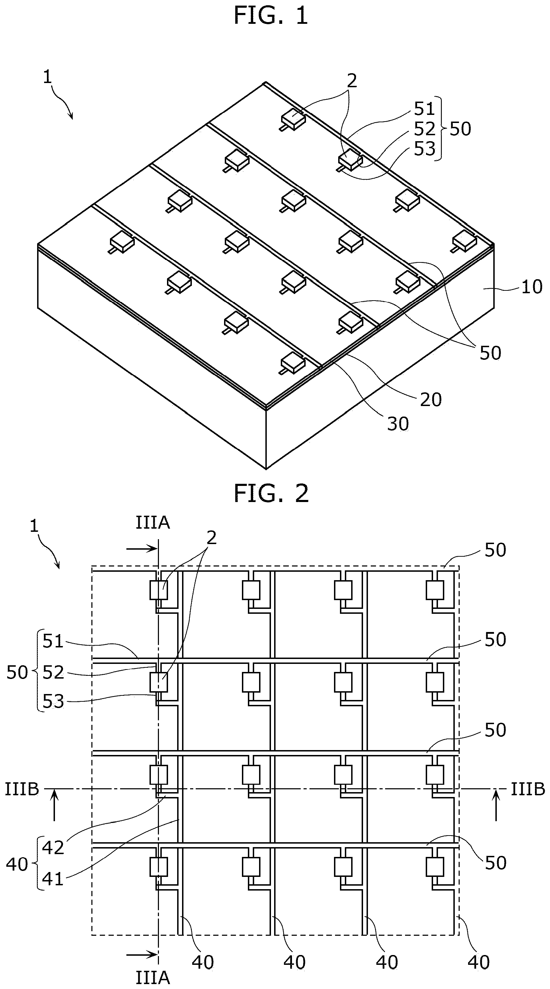

   FIG. 1 is a perspective view of a wiring board according to Embodiment 1.
[FIG. 2]
   FIG. 2 is a top view of the wiring board according to Embodiment 1.
[FIG. 3A]

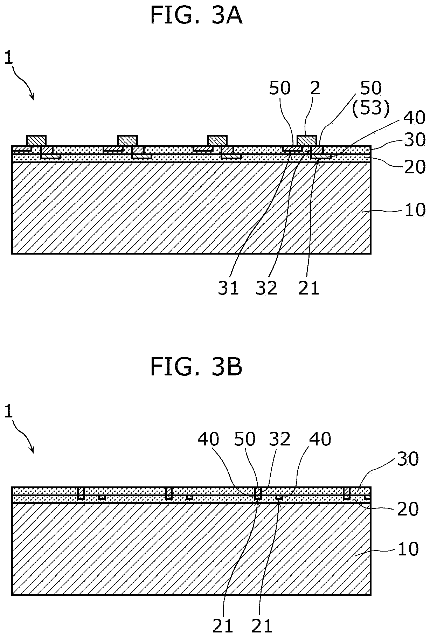

   FIG. 3A is a cross-sectional view of the wiring board according to Embodiment 1 taken along line IIIA-IIIA in FIG. 2.
[FIG. 3B]
   FIG. 3B is a cross-sectional view of the wiring board according to Embodiment 1 taken along line IIIB-IIIB in FIG. 2.
[FIG. 4A]

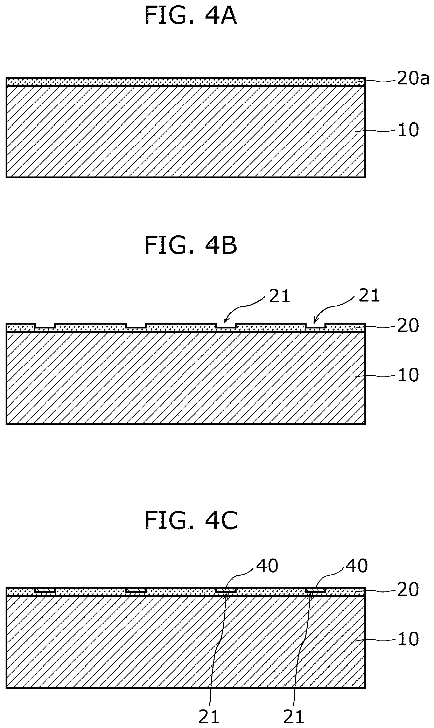

   FIG. 4A is a diagram for describing a process of forming a first insulating layer, in a method of manufacturing the wiring board according to Embodiment 1.
[FIG. 4B]
   FIG. 4B is a diagram for describing a process of forming first grooves in the first insulating layer, in the method of manufacturing the wiring board according to Embodiment 1.
[FIG. 4C]
   FIG. 4C is a diagram for describing a process of forming first wires, in the method of manufacturing the wiring board according to Embodiment 1.
[FIG. 4D]

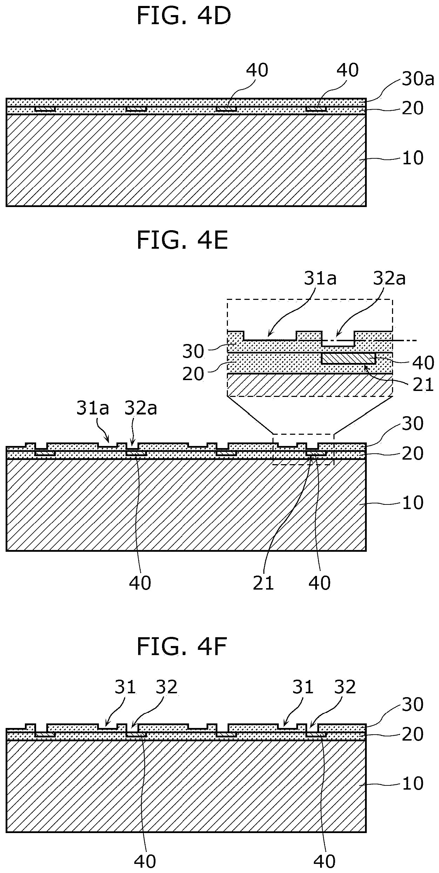

   FIG. 4D is a diagram for describing a process of forming a second insulating layer, in the method of manufacturing the wiring board according to Embodiment 1.
[FIG. 4E]
   FIG. 4E is a diagram for describing a process of forming first recesses and second recesses in the second insulating layer, in the method of manufacturing the wiring board according to Embodiment 1.
[FIG. 4F]
   FIG. 4F is a diagram for describing a process of forming first grooves and openings in the second insulating layer, in the method of manufacturing the wiring board according to Embodiment 1.
[FIG. 4G]

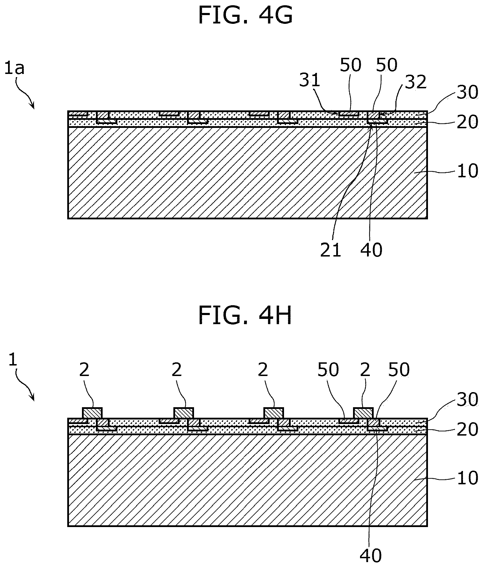

   FIG. 4G is a diagram for describing a process of forming second wires, in the method of manufacturing the wiring board according to Embodiment 1.
[FIG. 4H]
   FIG. 4H is a diagram for describing a process of mounting circuit elements, in the method of manufacturing the wiring board according to Embodiment 1.
[FIG. 5]

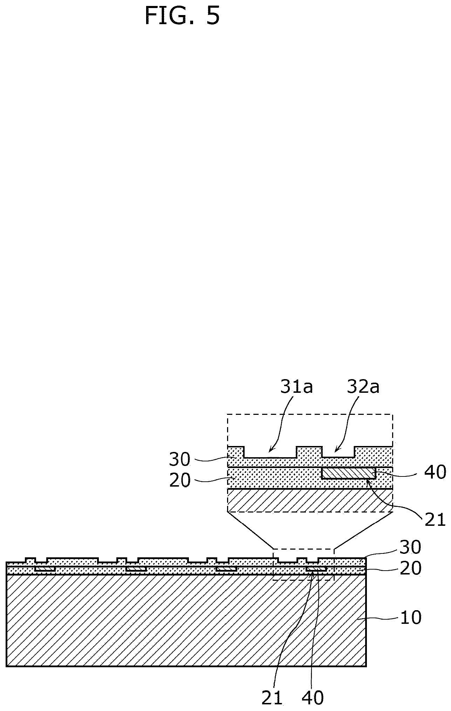

   FIG. 5 is a diagram for describing a process of forming first recesses and second recesses in the second insulating layer, in a method of manufacturing a wiring board according to a variation of Embodiment 1.
[FIG. 6]

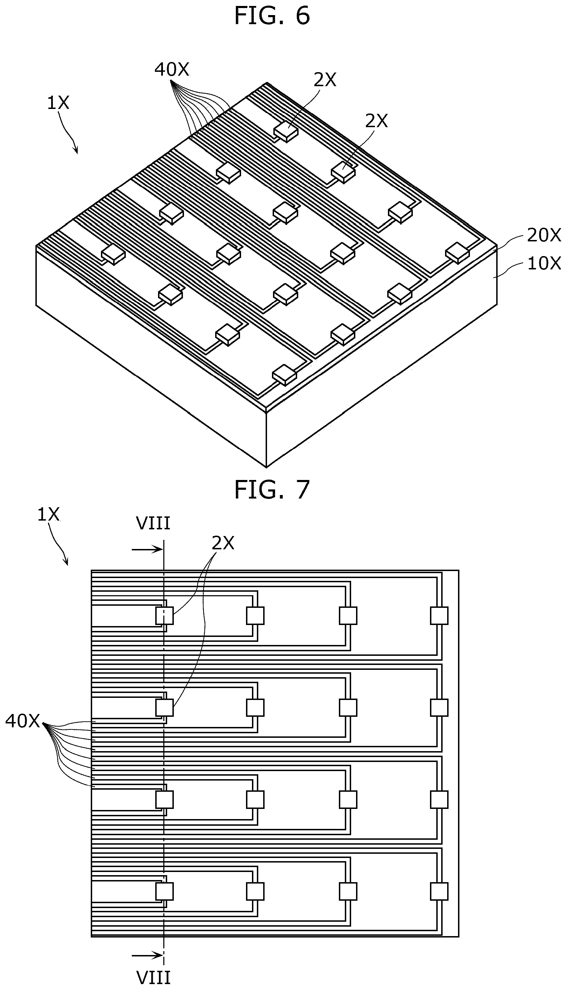

   FIG. 6 is a perspective view of a wiring board in Comparative Example 1.
[FIG. 7]
   FIG. 7 is a top view of the wiring board in Comparative Example 1.
[FIG. 8]

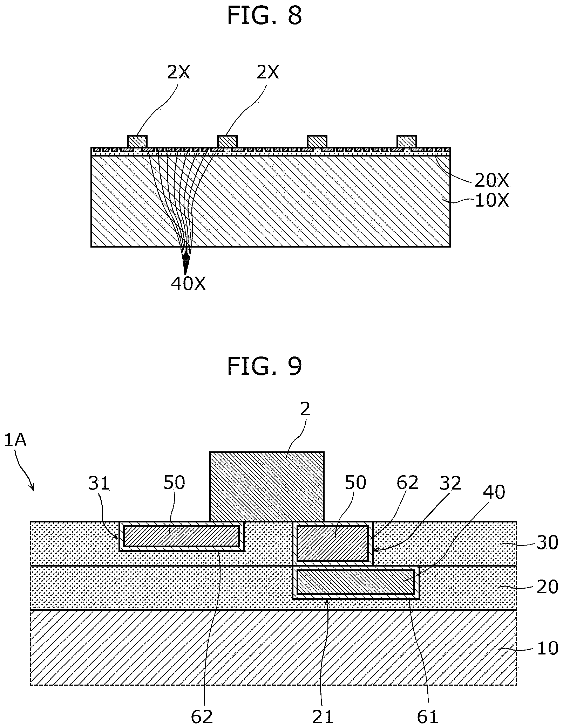

   FIG. 8 is a cross-sectional diagram of the wiring board in Comparative Example 1 taken along line VIII-VIII in FIG. 7.
[FIG. 9]
   FIG. 9 is a cross-sectional view of a wiring board according to a variation of Embodiment 1.
[FIG. 10]

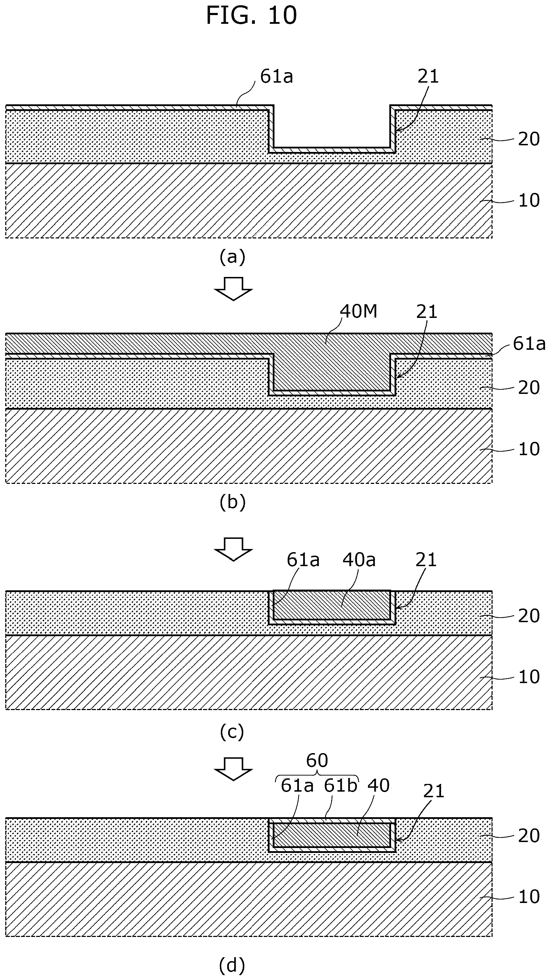

   FIG. 10 is a diagram for describing a method of forming a black layer in the first insulating layer.
[FIG. 11]

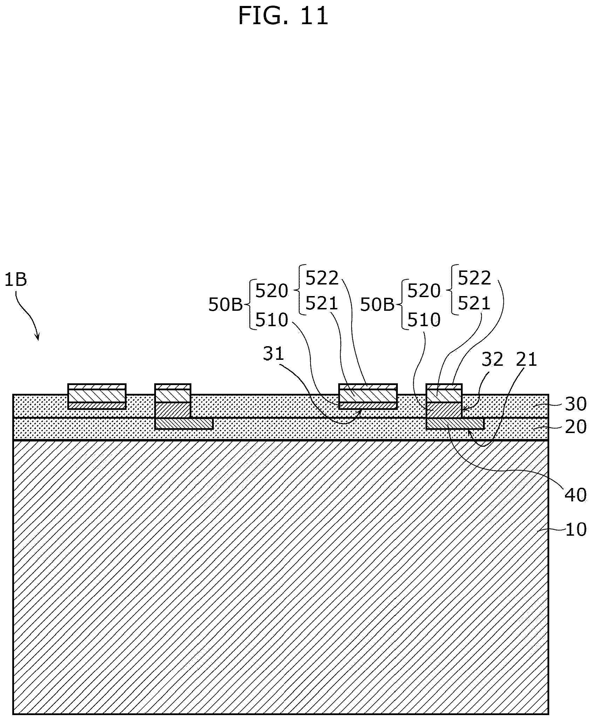

   FIG. 11 is a cross-sectional view of a wiring board according to Embodiment 2.
[FIG. 12]

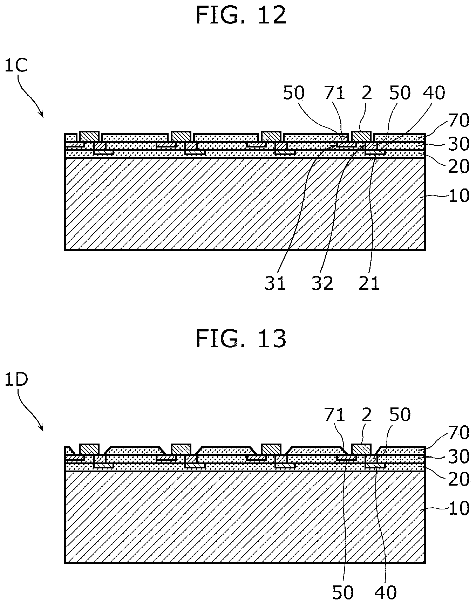

   FIG. 12 is a cross-sectional view of a wiring board according to Embodiment 3.
[FIG. 13]
   FIG. 13 is a cross-sectional view of a wiring board according to Variation 1 of Embodiment 3.
[FIG. 14]

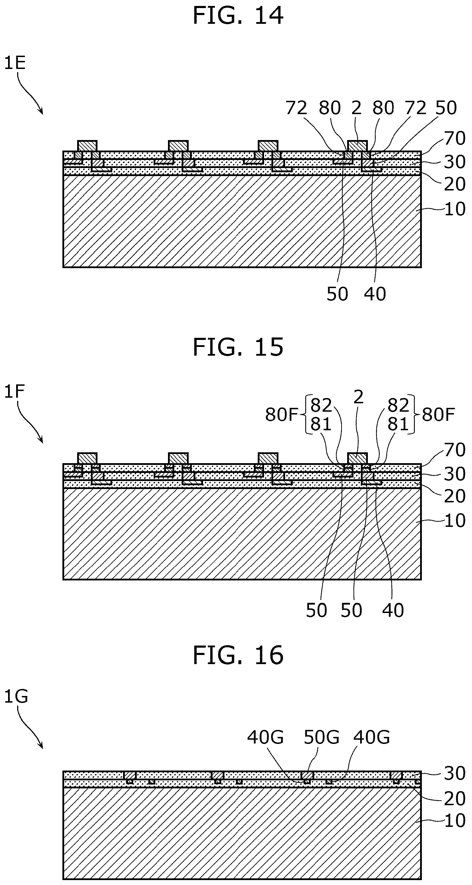

   FIG. 14 is a cross-sectional view of a wiring board according to Variation 2 of Embodiment 3.
[FIG. 15]
   FIG. 15 is a cross-sectional view of a wiring board according to Variation 3 of Embodiment 3.
[FIG. 16]
   FIG. 16 is a cross-sectional view of a wiring board according to Embodiment 4.
[FIG. 17]

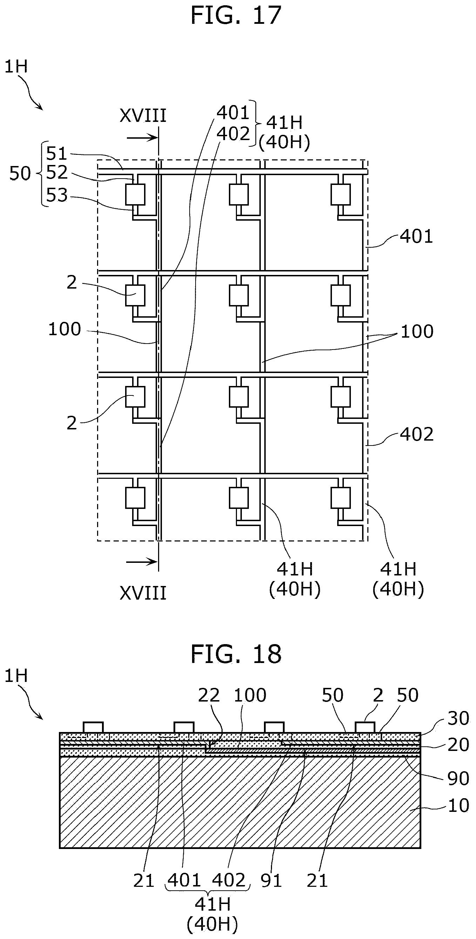

   FIG. 17 is a top view of a wiring board according to Embodiment 5.
[FIG. 18]
   FIG. 18 is a cross-sectional view of the wiring board according to Embodiment 5 taken along line XVIII-XVIII in FIG. 17.
[FIG. 19]

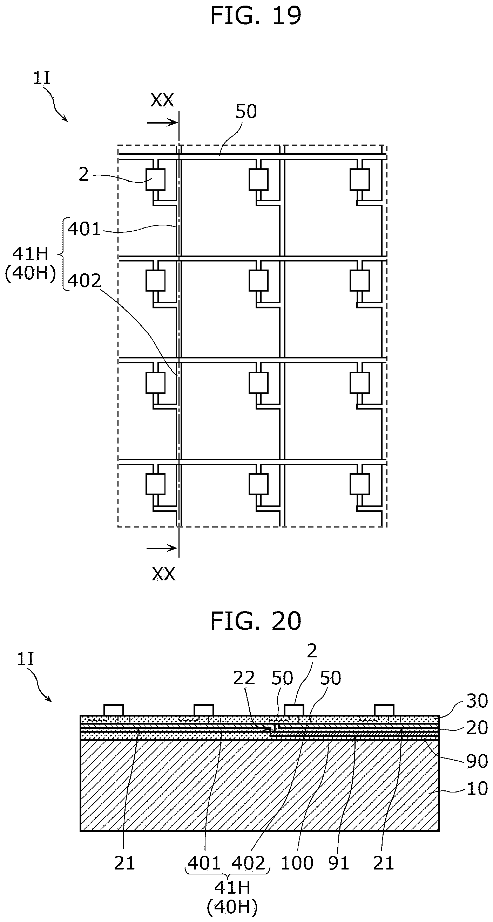

   FIG. 19 is a top view of a wiring board according to Variation 1 of Embodiment 5.
[FIG. 20]
   FIG. 20 is a cross-sectional view of the wiring board according to Variation 1 of Embodiment 5 taken along line XX-XX in FIG. 19.
[FIG. 21]

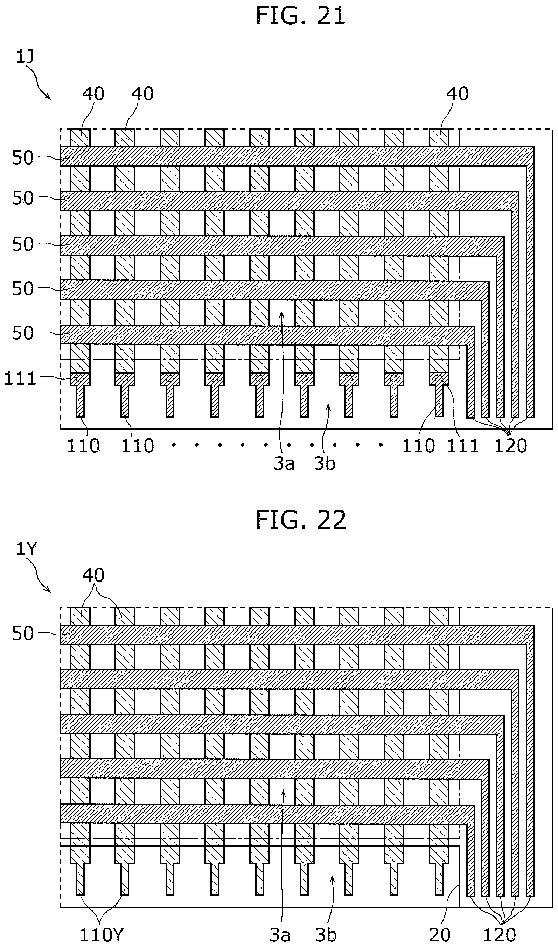

   FIG. 21 is a top view of a wiring board according to Embodiment 6.
[FIG. 22]
   FIG. 22 is a top view of a wiring board in Comparative Example 2.
[FIG. 23]

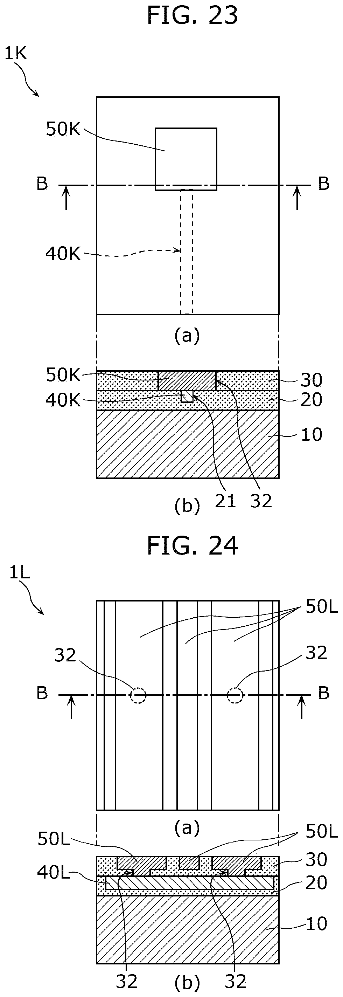

   FIG. 23 is a diagram illustrating the configuration of a wiring board according to Variation 1.
[FIG. 24]
   FIG. 24 is a diagram illustrating the configuration of a wiring board according to Variation 2.

### [Description of Embodiments]

Hereinafter, exemplary embodiments of the present disclosure will be described with reference to the Drawings. It should be noted that each of the embodiments described hereafter illustrates a specific example of the present disclosure. Therefore, numerical values, shapes, materials, structural elements, the arrangement and connection of the structural elements, and so on, indicated in the subsequent embodiments are mere examples, and thus are not intended to limit the present disclosure. Furthermore, among the structural elements in the subsequent embodiments, structural elements not recited in any one of the independent claims defining the most generic concepts of the present disclosure are described as arbitrary structural elements.

Furthermore, the respective figures are schematic diagrams and are not necessarily precise illustrations. Therefore, the scales, and so on, in the respective figures do not necessarily match. Furthermore, in the figures, elements which are substantially the same are given the same reference signs, and overlapping description is omitted or simplified.

### [EMBODIMENT 1]

First, the configuration of wiring board 1 according to Embodiment 1 will be described with reference to FIG. 1, FIG. 2, FIG. 3A, and FIG. 3B. FIG. 1 is a schematic diagram of wiring board 1 according to Embodiment 1. FIG. 2 is a top view of wiring board 1. FIG. 3A is a cross-sectional view of wiring board 1 taken along line IIIA-IIIA in FIG. 2, and FIG. 3B is a cross-sectional view of wiring board 1 taken along line IIIB-IIIB in FIG. 2. It should be noted that FIG. 1 to FIG. 3B illustrate a portion of wiring board 1.

Wiring board 1 includes film 10, first insulating layer 20, second insulating layer 30, first wires 40, and second wires 50. Wiring board 1 is a multilayer wiring board in which first wires 40 and second wires 50 are disposed at different heights.

Wiring board 1 according to the present embodiment further includes circuit elements 2. Specifically, wiring board 1 includes a plurality of circuit elements 2.

It should be noted that, although, in the present embodiment, wiring board 1 is a wiring board on which circuit elements 2 are mounted as illustrated in FIG. 1 to FIG. 3B, wiring board 1 may be a wiring board on which circuit elements 2 are not mounted. Furthermore, as in the present embodiment, wiring board 1 on which circuit elements 2 are mounted is a circuit module. As described later, in the present embodiment, circuit elements 2 are LED light sources, and thus wiring board 1 is a light source module.

Film 10 is a resin base film of wiring board 1. In the present embodiment, film 10 is a translucent substrate, and is made of a translucent resin material. In this case, film 10 is preferably a transparent substrate having high transmittance to such a degree that enables seeing through to the other side. As an example, film 10 is a transparent PET film made of polyethylene terephthalate (PET). It should be noted that the resin material making up film 10 is not limited to PET, and resin materials such as a cycloolefin-based resin, a polycarbonate-based resin, an acrylic-based resin, and so on, may be used. Furthermore, film 10 may be a rigid substrate or a flexible substrate.

First insulating layer 20 is located above film 10, and is stacked on film 10. In the present embodiment, first insulating layer 20 is formed directly on top of film 10. Therefore, the bottom face of first insulating layer 20 is in contact with the top face of film 10.

Second insulating layer 30 is located above first insulating layer 20, and is stacked on first insulating layer 20. In the present embodiment, second insulating layer 30 is formed directly on top of first insulating layer 20. Therefore, the bottom face of second insulating layer 30 is in contact with the top face of first insulating layer 20.

In this manner, in wiring board 1, the two insulating layers of first insulating layer 20 and second insulating layer 30 are stacked above film 10. First insulating layer 20 is a lower-layer insulating layer, and second insulating layer 30 is an upper-layer insulating layer. In the present embodiment, second insulating layer 30 is the uppermost layer of wiring board 1.

First insulating layer 20 and second insulating layer 30 are resin layers made of an insulating resin material. In the present embodiment, first insulating layer 20 and second insulating layer 30 are made of a translucent resin material. Specifically, first insulating layer 20 and second insulating layer 30 are made of a transparent resin material.

First insulating layer 20 and second insulating layer 30 are made of an insulating and translucent resin material. The resin material making up first insulating layer 20 and second insulating layer 30 is a thermosetting resin or an ultraviolet-curing resin material.

It should be noted that first insulating layer 20 and second insulating layer 30 may be made of the same resin material or may be made of different resin materials.

First insulating layer 20 includes first grooves 21. Each of first grooves 21 is a groove-shaped recess formed in such a way that the surface of first insulating layer 20 becomes recessed, and first groove 21 is formed in an elongated shape. Specifically, first grooves 21 are formed in straight lines.

Each of first grooves 21 includes a first base face and first lateral faces that are continuously connected to the first base face. In the present embodiment, the cross-sectional shape of first groove 21 when a cross-section is cut orthogonal to the lengthwise direction of first groove 21 is rectangular. In this cross-section, first groove 21 includes a first base face that is planar and a pair of first lateral faces that are both planar and face each other.

Since first insulating layer 20 is a single layer made of a single material, first insulating layer 20 is made of the same material in the first base face and the first lateral faces of first groove 21. In other words, in first insulating layer 20, the material from which the first base face is made and the material from which the first lateral faces are made is the same.

Conductive first wires 40 are formed in first grooves 21 of first insulating layer 20. In the present embodiment, first wires 40 are embedded inside of first grooves 21. In other words, first insulating layer 20 is a groove forming layer in which first grooves 21, into which first wires 40 are to be embedded, are formed. First wires 40 formed in first insulating layer 20, which is a lower-layer insulating layer, are lower-layer wires.

Each of first wires 40 is a conductor made of a conductive material. As an example, first wire 40 is a metal wire formed from a metal material such as copper, aluminum, or silver. In the present embodiment, first wire 40 is a copper wire made of copper. In this case, first wire 40 may be made of single element copper or may be made of a copper alloy. It should be noted that first wire 40 may be made of a conductive material other than copper.

Since first grooves 21 formed in first insulating layer 20 have first base faces in first insulating layer 20, the thickness of first wires 40 embedded inside first grooves 21 is less than the thickness of first insulating layer 20.

Like first grooves 21, first wires 40 are formed in an elongated shape. Specifically, like first grooves 21, first wires 40 are formed in straight lines.

First wire 40 has at least three faces. The cross-sectional shape of first wire 40 when a cross-section is cut orthogonal to the lengthwise direction of first wire 40 is the same as the cross-sectional shape of first groove 21. Therefore, in the present embodiment, the cross-sectional shape of first wire 40 is rectangular.

Specifically, in a cross-section orthogonal to the lengthwise direction of first wire 40, first wire 40 has four faces consisting of a bottom face, a pair of lateral faces, and a top face. The bottom face and the pair of lateral faces of first wire 40 are in contact with the base face and the pair of lateral faces of first groove 21, respectively. Furthermore, the top face of first wire 40 may or may not be flush with the top face of first insulating layer 20. In this case, first wire 40 may be formed in such a way that the center portion in the wire width is slightly depressed. Therefore, the top face of first wire 40 may or may not be in contact with the bottom face of second insulating layer 30. It should be noted that, as described later, a portion of the top face of first wire 40 is in contact with second wire 50.

Second insulating layer 30 includes second grooves 31. Each of second grooves 31 is a groove-shaped recess formed in such a way that the surface of second insulating layer 30 becomes recessed, and second groove 31 is formed in an elongated shape. Specifically, second grooves 31 are formed in straight lines.

Each of second grooves 31 includes a second base face and second lateral faces that are continuously connected to the second bottom face. In the present embodiment, the cross-sectional shape of second groove 31 when a cross-section is cut orthogonal to the lengthwise direction of second groove 31 is rectangular. In this cross-section, second groove 31 includes a second base face that is planar and a pair of second lateral faces that are both planar and face each other.

Since second insulating layer 30 is a single layer made of a single material, second insulating layer 30 is made of the same material in the second base face and the second lateral faces of second groove 31. In other words, in second insulating layer 30, the material from which the second base face is made and the material from which the second lateral faces are made is the same.

Furthermore, second insulating layer 30 includes openings 32 located above first wires 40. Openings 32 are through holes that penetrate through second insulating layer 30. Therefore, the depth of openings 32 is greater than the depth of second grooves 31.

Conductive second wires 50 are formed in second grooves 31 and openings 32 in second insulating layer 30. In the present embodiment, second wires 50 are embedded inside second grooves 31 and openings 32. In other words, second insulating layer 30 is a groove forming layer in which second grooves 31, into which second wires 50 are to be embedded, are formed. Second wires 50 formed in second insulating layer 30, which is an upper-layer insulating layer, are upper-layer wires.

Like first wires 40, each of second wires 50 is a conductor made of a conductive material. As an example, second wire 50 is a metal wiring formed from a metal material such as copper, aluminum, or silver. In the present embodiment, second wire 50 is made of the same conductive material as first wire 40. In the present embodiment, second wire 50 is a copper wiring made of copper. In this case, second wire 50 may be made of single element copper or may be made of a copper alloy. It should be noted that second wire 50 may be made of a conductive material other than copper. Furthermore, second wire 50 may be made of a different material as first wire 40.

Since second grooves 31 formed in second insulating layer 30 have second base faces in second insulating layer 30, the thickness of second wires 50 embedded inside second grooves 31 is less than the thickness of second insulating layer 30. Furthermore, since openings 32 formed in second insulating layer 30 penetrate through second insulating layer 30, the thickness of second wires 50 embedded in openings 32 is the same as the thickness of second insulating layer 30, but is not limited to such thickness. For example, when the center portion in the wire width of second wire 50 is slightly depressed, there are instances where the thickness of second wire 50 and the thickness of second insulating layer 30 are different. Specifically, the thickness of at least a portion of second wires 50 formed in second grooves 31 may be less than the thickness of second insulating layer 30.

Like second grooves 31, second wires 50 formed in second grooves 31 are formed in an elongated shape. Specifically, like second grooves 31, second wires 50 formed in second grooves 31 are formed in straight lines. It should be noted that second wires 50 formed openings 32 are formed in a land-shape in a top view, but may be formed in an elongated shape.

Second wires 50 formed in second grooves 31 have at least three faces. The cross-sectional shape of second wire 50 when a cross-section is cut orthogonal to the lengthwise direction of second wire 50 is the same as the cross-sectional shape of second groove 31. Therefore, in the present embodiment, the cross-sectional shape of second wires 50 formed in second grooves 31 is rectangular.

Specifically, in a cross-section orthogonal to the lengthwise direction of second wire 50 formed in second groove 31, second wire 50 has four faces consisting of a bottom face, a pair of lateral faces, and a top face. In this case, the bottom face and the pair of lateral faces of second wire 50 are in contact with the base face and the pair of lateral faces of second groove 31, respectively. Furthermore, the top face of second wire 50 formed in second groove 31 may or may not be flush with the top face of second insulating layer 30. In this case, second wire 50 may be formed in such a way that the center portion in the wire width is slightly depressed.

Furthermore, the cross-sectional shape of second wire 50 formed in opening 32 is also rectangular. Furthermore, the top face of second wires 50 formed in openings 32 may or may not be flush with the top face of second insulating layer 30. In this case, second wire 50 formed in opening 32 may be formed in such a way that the center portion in the wire width is slightly depressed.

The bottom face of second wire 50 formed in opening 32 and the top face of first wire 40 are joined together. In other words, the bottom face of second wire 50 formed in opening 32 is in contact with the top face of first wire 40. Therefore, second wire 50 embedded inside opening 32 is a via, and first wire 40 and second wire 50 are connected via opening 32 (via hole). In this manner, each of openings 32 formed in second insulating layer 30 functions as a contact that connects first wire 40 and second wire.

Here, an example of a layout of first wires 40 and second wires 50 of wiring board 1 according to the present embodiment will be described with reference to FIG. 2.

First wires 40 each include first main wire 41 that extends in the column direction (first direction) and a plurality of first branch wires 42 that branch off from first main wire 41. First branch wires 42 extend linearly in the row direction (second direction) orthogonal to the column direction.

Second wires 50 each include second main wire 51 that extends in the row direction (second direction), a plurality of second branch wires 52 that branch off from second main wire 51, and a plurality of contact wires 53 that are connected to first wires 40. Second branch wires 52 extend linearly in the column direction (first direction). Contact wire 53 is disposed spaced apart from second branch wire 52 in the column direction, and is electrically connected to such second branch wire 52 via circuit element 2.

First main wires 41 of first wires 40 and second main wires 51 of second wires 50 three-dimensionally cross each other. First branch wires 42 of first wires 40 are connected to contact wires 53 of second wires 50. Specifically, first branch wires 42 of first wire 40 is connected to contact wires 53 via openings 32 formed in second insulating layer 30.

Circuit elements 2 are arranged in a matrix. Specifically, circuit elements 2 are disposed near crossing points at which first main wires 41 of first wires 40 and second main wires 51 of second wires 50 three-dimensionally cross each other.

Each circuit element 2 includes a pair of electrodes. One of the pair of electrodes of circuit element 2 is connected to second branch wire 52 of second wire 50. The other of the pair of electrodes of circuit element 2 is connected to contact wire 53 connected to first wire 40. Accordingly, the pair of electrodes of circuit element 2 are connected to a pair of first wire 40 and second wire 50.

In the present embodiment, circuit element 2 is a light-emitting element. As an example, circuit element 2 is an LED light source including an LED. In this case, an LED light source that is of the surface mount device (SMD) type in which an LED chip is mounted inside a package can be used for circuit element 2 which is an LED light source. The SMD-type LED light source includes, in a back face, an anode electrode and a cathode electrode.

For example, the anode electrode of the LED light source is connected to second branch wire 52 of second wire 50, and the cathode electrode of the LED light source is connected to contact wire 53 connected to first wire 40.

Wiring board 1 configured in the above-described manner can drive circuit elements 2 by using a column-driving driver IC that supplies current to first wires 40 including a plurality of first main lines 41 extending in the column direction and a row-driving driver IC that supplies current to second wires 50 including a plurality of second main lines 51 extending in the row direction.

In the present embodiment, since circuit elements 2 are LED light sources, the turning ON and OFF of a plurality of LED light sources can be controlled by using the column-driving driver IC and the row-driving driver IC. Specifically, a plurality of LED light sources can be controlled individually (selectively) according to a simple matrix driving scheme. In this manner, by controlling the turning ON and OFF of the plurality of LED light sources that are arranged in a matrix, it is possible to display an image with the plurality of LED light sources are pixels. In other words, wiring board 1 according to this embodiment is a display device that can be utilized in a display apparatus. In particular, since film 10, first insulating layer 20, and second insulating layer 30 are transparent in the present embodiment, wiring board 1 according to the present embodiment is a transparent wiring board, and can be used in a transparent display apparatus.

Next, a method of manufacturing wiring board 1 according to Embodiment 1 will be described with reference to FIG. 4A to FIG. 4H. FIG. 4A to FIG. 4H are diagrams for describing respective processes in the method of manufacturing wiring board 1 according to Embodiment 1.

First, as illustrated in FIG. 4A, film 10 is prepared, and first groove forming layer 20a made of a resin material is disposed on film 10. In the present embodiment, a PET film is used as film 10. In addition, as first groove forming layer 20a, an insulating and translucent resin material is applied in an uncured state (liquid state) on the surface of film 10. The liquid resin material making up first groove forming layer 20a can be applied using an application device such as a dispenser, or the like.

Next, as illustrated in FIG. 4B, first insulating layer 20 including first grooves 21 is formed by forming first grooves 21 in first groove forming layer 20a.

Specifically, by pressing a first transfer plate, which is a mold having a concave-convex structure, onto the surface of first groove forming layer 20a which is a resin material in the liquid state, the concave-convex structure of the first transfer plate is transferred onto first groove forming layer 20a. In other words, first grooves 21 which correspond to the convex portions of the concave-convex structure of the first transfer plate are formed in first groove forming layer 20a. Then, first groove forming layer 20a which is a resin material in the liquid state is cured in a state in which the first transfer plate is pressed onto first groove forming layer 20a. Subsequently, the first transfer plate is peeled off from film 10. Accordingly, as illustrated in FIG. 4B, first insulating layer 20 in which grooves 21 are formed can be formed.

Next, as illustrated in FIG. 4C, first wires 40 are formed in first grooves 21 of first insulating layer 20. Specifically, first wires 40 made of copper are formed to fill in first grooves 21.

For example, first wires 40 can be formed by embedding a conductive material (plating material) such as copper, or the like, in first grooves 21, by plating. Alternatively, first wires 40 may be formed by applying the conductive material in first grooves 21.

It should be noted that, when the conductive material protrudes from first grooves 21, first wires 40 embedded in first grooves 21 can be formed so that the top face of first insulating layer 20 and the top face of first wires 40 are flush, by either removing only the protruding conductive material or removing the protruding conductive material together with a surface layer of first insulating layer 20. Moreover, when forming first wires 40 to have a slightly depressed center portion in the wire width, and so on, the top face of first insulating layer 20 and the top face of first wires 40 need not be flush.

Next, as illustrated in FIG. 4D, second groove forming layer 30a made of a resin material is disposed on first insulating layer 20 in which first wires 40 have been formed in first grooves 21. In the present embodiment, as second groove forming layer 30a, an insulating and translucent resin material is applied in an uncured state (liquid state) on the surface of first insulating film 20, in the same manner as in first groove forming layer 20a. The liquid resin material making up second groove forming layer 30a can be applied using an application device such as a dispenser, or the like.

Next, as illustrated in FIG. 4E, second insulating layer 30 including first recesses 31a and second recesses 32a is formed by forming first recesses 31a corresponding to second grooves 31 and second recesses 32a corresponding to openings 32 in second groove forming layer 30a.

Specifically, by pressing a second transfer plate, which is a mold having a concave-convex structure, onto the surface of second groove forming layer 30a which is a resin material in the liquid state, the concave-convex structure of the second transfer plate is transferred onto second groove forming layer 30a. In other words, first recesses 31a and second recesses 32a which correspond to first convex portions and second convex portions of the concave-convex structure of the second transfer plate are formed in second groove forming layer 30a. Then, second groove forming layer 30a which is a resin material in the liquid state is cured in a state in which the second transfer plate is pressed onto second groove forming layer 30a. Subsequently, the first transfer plate is peeled off from film 10. Accordingly, as illustrated in FIG. 4E, second insulating layer 30 in which first recesses 31a and second recesses 32a are formed can be formed. It should be noted that, since second recesses 32a correspond to openings 32, second recesses 32a are formed above first wires 40.

At this time, as illustrated in the enlarged view in FIG. 4E, in the present embodiment, the depth of second recess 32a is greater than the depth of first recess 31a. In other words, the depth of second recess 32a relative to opening 32 is made to be deeper in advance than the depth of first recess 31a relative to second groove 31. First recess 31a and second recess 32a that have different depths can be formed, for example, by making the heights of the concave and convex portions of the mold (transfer plate) different in advance.

Next, as illustrated in FIG. 4F, second grooves 31 and openings 32 are formed in second insulating layer 30 by removing the bottom portions of first recesses 31a and second recesses 32a. Specifically, by ashing the entirety of second insulating layer 30 that has been made deeper in advance than the depth of first recesses 31a, the surface layer of the entirety of second insulating layer 30 can be removed. Accordingly, second grooves 31 can be formed by deepening the bottom of first recesses 31a and openings 32 can be formed by penetrating through the bottom of second recesses 32a. In other words, openings 32 penetrate through second insulating layer 30.

For example, the surface layer of the entirety of second insulating layer 30 can be removed by using oxygen plasma, ions, or ozone. It should be noted that it is also acceptable to remove only the bottoms of first recesses 31a and second recesses 32a using a short wavelength laser with a wavelength of 172 nm or an excimer laser.

Next, as illustrated in FIG. 4G, second wire 50 is formed in second groove 31 and opening 32 of second insulating layer 30. Specifically, second wire 50 is formed to fill in second groove 31 and opening 32.

For example, in the same manner as when forming first wires 40, second wires 50 can be formed by embedding a conductive material (plating material) in second grooves 31 and openings 32 by plating, or second wire 50 can be formed by applying the conductive material in second grooves 31.

It should be noted that, when the conductive material protrudes from second grooves 31, second wires 50 embedded in second grooves 31 and openings 32 can be formed so that the top face of second insulating layer 30 and the top face of second wires 50 are flush, by either removing only the protruding conductive material or removing the protruding conductive material together with a surface layer of second insulating layer 30. Moreover, when forming second wires 50 to have a slightly depressed center portion in the wire width, and so on, the top face of second insulating layer 30 and the top face of second wires 50 need not be flush.

In this manner, by forming second wires 50 in openings 32 that penetrate through second insulating layer 30, first wires 40 and second wires 50 can be joined. Accordingly, it is possible to form wiring board 1a which is a multilayer wiring board in which first wires 40 and second wires 50 are formed in different wire layers and first wires 40 and second wires 50 are partially joined.

Next, as illustrated in FIG. 4H, circuit elements 2 are mounted on wiring board 1a in which first wires 40 and second wires 50 are formed. Accordingly, wiring board 1 on which circuit elements 2 are mounted can be obtained. Specifically, in the present embodiment, LED light sources can be mounted as circuit elements 2. In this case, for example, the electrodes of the LED light sources and second wires 50 can be joined by solder, or the like.

It should be noted that, in the present embodiment, although first recesses 31a and second recesses 32a having different depths are formed in advance when forming second grooves 31 and openings 32 in second insulating layer 30 as illustrated in FIG. 4E, the present disclosure is not limited to such process. For example, as illustrated in FIG. 5, second grooves 31 and openings 32 may be formed in second insulating layer 30 by forming first recesses 31a and second recesses 32a that have the same depth and removing and penetrating through the bottom of only second recesses 32a using a laser. It should be noted that FIG. 5 corresponds to the process (i.e., the process of forming first recesses 31a and second recesses 32a in second insulating layer 30) in FIG. 4E described above.

Next, the effects of wiring board 1 according to Embodiment 1, including the circumstances leading to the technique of the present disclosure, will be described with comparison to wiring board 1X in Comparative Example 1. FIG. 6 is a perspective view of wiring board 1X in Comparative Example 1. FIG. 7 is a top view of wiring board 1X in Comparative Example 1. FIG. 8 is a cross-sectional diagram of wiring board 1X in Comparative Example 1 taken along line VIII-VIII in FIG. 7.

As illustrated in FIG. 6 to FIG. 8, wiring board 1X in Comparative Example 1 includes film 10X, insulating layer 20X formed on film 10X, and wires 40X formed in grooves 21X of insulating layer 20X. Wiring board 1X in Comparative Example 1 further includes a plurality of LED light sources 2X that are arranged in a matrix. In wiring board 1X in Comparative Example 1, wires 40X are formed by imprinting.

As illustrated in FIG. 8, in wiring board 1X in Comparative Example 1 formed in the above-described manner, since wires 40X are formed in a single wiring layer 20X, when wires 40X are formed in a pattern for matrix-driving the plurality of LED 2X arranged in a matrix, there are regions where many wires 40X need to be formed between adjacent LED light sources 2X, as illustrated in FIG. 6 and FIG. 7.

As a result, the proportion occupied by wires 40X when wiring board 1X is viewed from the top becomes large. In other words, the area of wires 40X when wiring board 1X is viewed from the top becomes large. Accordingly, the interval between LED light sources 2X cannot be reduced, and thus displaying a high-definition image is not possible.

Furthermore, although wiring board 1X in Comparative Example 1 is a transparent device in which film 10, first insulating layer 20 and second insulating layer 30 are transparent, when there are regions where many wires 40X need to be formed between adjacent LED light sources 2X, the transmittance of wiring board deteriorates because wires 40X are light-blocking components.

In contrast, as illustrated in FIG. 1 to FIG. 3B, in wiring board 1 according to the present embodiment, first insulating layer 20 and second insulating layer 30 are stacked above film 10 which is made of resin, first wires 40 are formed in first grooves 21 of first insulating layer 20 which is the lower-layer insulating layer, and second wires 50 are formed in second grooves 31 and openings 32 of second insulating layer 30 which is the upper-layer insulating layer. In addition, the top face of first wires 40 which is the lower-layer wiring and the bottom face of second wires 50, which is the upper-layer wiring, formed in openings 32 of second insulating layer 30 are joined together.

With this configuration, the wires of wiring board 1 can be divided into first wires 40 and second wires 50 in the two layers of first insulating layer 20 and second insulating layer 30. Accordingly, even when the wiring layout becomes complex due to a lot of circuit elements 2 being disposed on wiring board 1, the proportion occupied by the wires when wiring board 1 is viewed from the top can be reduced. In other words, the area of the wires when wiring board 1 is viewed from the top can be made smaller. For example, when circuit elements 2 are arranged in a matrix on wiring board 1, the area of the wires as a whole when wiring board 1 is viewed from the top can be made smaller compared to wiring board 1X in Comparative Example 1.

Furthermore, since wiring board 1 is a transparent wiring board in the present embodiment, reducing the proportion occupied by wires when wiring board 1 is viewed from the top makes it possible to reduce the transmittance of wiring board 1. In the present embodiment, the transmittance of regions in which first wires 40 and second wires 50 are not formed when wiring board 1 is viewed from the top is at least 80 percent, and can be further increased to 85 percent.

In addition, with the configuration of wiring board 1 according to the present embodiment, second wires 50 that are embedded in second grooves 31 to extend linearly and second wires 50 that are embedded in openings 32 to serve as vias can be formed at the same time and from the same material.

Furthermore, with the configuration of wiring board 1 according to the present embodiment, first wires 40 and second wires 50 can easily be made thicker, and thus the resistance of first wires 40 and second wires 50 can be lowered.

Furthermore, a black layer may be formed on a portion or the entirety of the surface of at least one of first wires 40 or second wires 50. For example, first wire 40 and second wire 50 have at least three faces, and a black layer may be formed on at least one of these three faces. In this case, the black layer is preferably formed on all the faces of at least one of first wire 40 or second wire 50.

An example of the black layer will be described with reference to FIG. 9. FIG. 9 is a cross-sectional view of wiring board 1A according to a variation of Embodiment 1. FIG. 9 illustrates a magnified view of a surrounding structure of one circuit element 2.

With regard to both first wires 40 and second wires 50, in wiring board 1A illustrated in FIG. 9, black layers are formed on all of the faces of each of first wires 40 and second wires 50.

Specifically, black layer 61 is formed on each of the bottom face, the pair of lateral faces, and the top face of first wires 40. Therefore, black layer 61 is formed on all faces of first grooves 21 of first insulating layer 20.

Furthermore, black layer 62 is formed on each of the bottom face, the pair of lateral faces, and the top face of second wires 50. Therefore, black layer 62 is formed on all faces of second grooves 31 of second insulating layer 30.

Black layer 61 to be formed on the surfaces of first wire 40 is preferably formed at least on the top face of first wire 40. In the same manner, black layer 62 to be formed on the surfaces of second wire 50 is preferably formed at least on the top face of second wire 50. Accordingly, light entering from the top side of wiring board 1 can be blocked by black layers 61 and 62.

Black layer 61 covering first wires 40 can be formed according to the method illustrated in FIG. 10. FIG. 10 is a diagram for describing a method of forming black layer 61 on first wires 40.

Specifically, as illustrated in FIG. 4B described above, after first groove 21 is formed in first insulating layer 20, black film 61a is formed to cover the faces of first groove 21 as illustrated in (a) in FIG. 10. Black film 61a is a layer containing at least one type of metal selected from a group that includes Ti, Al, V, W, Ta, Si, Cr, Ag, Mo, Cu, and Zn, for example. In the present embodiment, by depositing black film 61a on the entire surface of first insulating layer 20, black film 61a is deposited on the entirety of the portion of first insulating layer 20 in which first groove 21 has been formed as well as the portion in which first groove 21 is not formed. Black film 61a can be formed, for example, by sputtering.

Next, as illustrated in (b) in FIG. 10, metal film 40M is formed on black film 61a to fill in first groove 21 in which black film 61a has been formed. In this case, by depositing copper by plating with black film 61a as a base film (nucleus), metal film 40M made of a plating film is formed on black film 61a.

Next, as illustrated in (c) in Fig. 10, metal film 40M is removed in such a way as to leave metal film 40M that is embedded in first groove 21. In this case, metal film 40M is removed until black film 61a that is formed on the portion of first insulating layer 20 in which first groove 21 is not formed is removed. Accordingly, black film 61a formed on the faces of first groove 21 is left behind and metal film 40M that is embedded in first groove 21 also left behind. Metal film 40M embedded in first groove 21 becomes first wire 40.

Next, as illustrated in (d) in FIG. 10, the top face layer of first wire 40a formed in first groove 21 is blackened to form blackened film 61b. In the present embodiment, the upper layer portion of first wire 40a (plating film) has been replaced with a blackened film.

In this manner, by blackening the surface layer of first wire 40a formed in first groove 21 to form blackened film 61b, black film 61 can be formed to cover the entirety of the four faces of first wire 40. Black film 61 formed in this manner is composed of black film 61a which covers the bottom face and the pair of lateral faces of first wire 40 and blackened film 61b which covers the top face of first wire 40.

It should be noted that, although not illustrated in the figures, black film 62 covering second wires 50 can be formed using the same method as that for black film 61.

### [Embodiment 2]

First, wiring board 1B according to Embodiment 2 will be described with reference to FIG. 11. FIG. 11 is a cross-sectional view of wiring board 1B according to Embodiment 2.

Wiring board 1B according to the present embodiment and wiring board 1 according to Embodiment 1 described above are different in terms of the configuration of second wires 50B. Specifically, in wiring board 1 according to Embodiment 1 described above, second wires 50 are made of one type of material, whereas in wiring board 1B according to the present embodiment, second wires 50B are made of two or more types of materials.

As illustrated in FIG. 11, second wires 50B are formed in second grooves 31 and openings 32 of second insulating layer 30. Second wire 50B formed in each of second groove 31 and opening 32 includes first conducting layer 510 and second conducting layer 520.

First conducting layer 510 is the lowermost layer of second wire 50B and is formed in each of second groove 31 and opening 32. Therefore, the bottom face of first conducting layer 510 formed in opening 32 is the bottom face of second wire 50B, and is joined to the top face of first wire 40 formed in first groove 21 of first insulating layer 20.

Second conducting layer 520 is formed on first conducting layer 510. Second conducting layer 520 is one or more layers, that is, it is composed of one layer or a plurality of layers. In the present embodiment, second conducting layer 520 is composed of the two layers of lower conducting layer 521 and upper conducting layer 522. Lower conducting layer 521 is formed on first conducting layer 510, and upper conducting layer 522 is formed on lower conducting layer 521.

Second conducting layer 520 may be formed without protruding from second groove 31 and opening 32, and may be formed to protrude from second groove 31 and opening 32. In the present embodiment, second conducting layer 520 protrudes from second groove 31 and opening 32. Specifically, in second conducting layer 520, a portion of lower conducting layer 521 protrudes from second groove 31 and opening 32, and upper conducting layer 522 protrudes from second groove 20 and opening 32.

First conducting layer 510 and second conducting layer 520 are made of a conductive material such as a metal material, but first conducting layer 510 and second conducting layer 520 are made of different materials. In the present embodiment, first conducting layer 510 is a copper layer made of copper. Lower conducting layer 521 of second conducting layer 520 is a nickel layer made of nickel, and upper conducting layer 522 of second conducting layer 520 is a gold layer made of gold. In other words, second wire 50B has a stacked structure of a copper layer, a nickel layer, and a gold layer. In this case, the nickel layer and the gold layer can be formed by plating.

It should be noted that first wire 40 formed in first groove 21 of first insulating layer 20 is made of copper only, as in Embodiment 1 described above. In other words, first wire 40 according to the present embodiment is formed from on type of material. For this reason, in the present embodiment, first wire 40 and second wire 50B are made of different conductive materials.

As described above, in the same manner as in Embodiment 1 described above, even in wiring board 1B according to the present embodiment, first insulating layer 20 and second insulating layer 30 are stacked above film 10 which is made of resin, first wires 40 are formed in first grooves 21 of first insulating layer 20 which is the lower-layer insulating layer, and second wires 50B are formed in second grooves 31 and openings 32 of second insulating layer 30 which is the upper-layer insulating layer. In addition, the top face of first wires 40 which are the lower-layer wires and the bottom face of second wires 50B, which are the upper-layer wires, formed in openings 32 of second insulating layer 30 are joined together.

With this configuration, wiring board 1B according to the present embodiment also achieves advantageous effects such as being able to reduce the proportion occupied by wires when wiring board 1B is viewed from the top, and improve the transmittance of wiring board 1B.

Furthermore, in wiring board 1B according to the present embodiment, a plurality of circuit elements 2 can be mounted, in the same manner as in Embodiment 1 described above. In this case, in wiring board 1B according to the present embodiment, first wire 40 and second wire 50B are made of different conductive materials.

With this configuration, the conductive material of second wires 50B can be selected to improve the joinability between second wires 50B and the electrodes of circuit elements 2.

In the present embodiment, second wire 50B includes first conducting layer 510 made of copper and second conducting layer 520 formed on first conducting layer 510, and second conducting layer 520 includes lower conducting layer 521 made of a nickel layer and upper conducting layer 522 made of a gold layer.

With this configuration, it is possible to improve joinability when second wires 50B and the electrodes of circuit elements 2 are joined using solder, or the like.

It should be noted that although first wire 40 is made of one type of material and only second wire 50B is made of two or more types of materials in the present embodiment, the present disclosure is not limited to this configuration. For example, each of first wire 40 and second wire 50B may be formed from two or more types of materials. Specifically, it is sufficient that at least one of first wire 40 or second wire 50B is formed from two or more types of materials. Furthermore, aside from first wire 40 and second wire 50B, two or more types of metal materials may be used for all of the wires of wiring board 1B including first wire 40 and second wire 50B.

### [Embodiment 3]

Next, wiring board 1C according to Embodiment 3 will be described with reference to FIG. 12. FIG. 12 is a cross-sectional view of wiring board 1C according to Embodiment 3.

As illustrated in FIG. 12, wiring board 1C according to the present embodiment includes third insulating layer 70 in addition to the configuration of wiring board 1 according to Embodiment 1 described above.

Third insulating layer 70 is located above second insulating layer 30, and is stacked on second insulating layer 30. In the present embodiment, third insulating layer 70 is formed directly on top of second insulating layer 30. Therefore, the bottom face of third insulating layer 70 is in contact with the top face of second insulating layer 30. In this manner, in wiring board 1C, the three insulating layers of first insulating layer 20, second insulating layer 30, and third insulating layer 70 are stacked above film 10. In the present embodiment, third insulating layer 70 is the uppermost layer of wiring board 1C.

Third insulating layer 70 is made of an insulating resin material or an insulating inorganic material. In the present embodiment, third insulating layer 70 is made of a translucent resin material or a translucent inorganic material. Specifically, third insulating layer 70 is made of a transparent resin material or a transparent inorganic material.

When third insulating layer 70 is to be made of an insulating resin material, the same material as in first insulating layer 20 and second insulating layer 30 can be used as the material of third insulating layer 70. Furthermore, when third insulating layer 70 is to be made of an insulating inorganic material, a silicon dioxide film, or the like, can be used as third insulating layer 70.

Third insulating layer 70 includes through holes 71. Each of through holes 71 can be formed after third insulating layer 70 is deposited. Through hole 71 formed in third insulating layer 70 is formed above second wire 50. At least a portion of second wire 50 is exposed from through hole 71. Specifically, in the present embodiment, through hole 71 that exposes at least a portion of second wire 50 formed in second groove 31 is formed in third insulating layer 70 which is the uppermost layer of wiring board 1C.

Through hole 71 is a hollow formed in third insulating layer 70 which is the uppermost layer. Circuit element 2 is disposed in this through hole 71. In the present embodiment, a plurality of through holes 71 are formed in third insulating layer 70, and circuit element 2 is disposed in each of through holes 71. In other words, through hole 71 is a recess that circuit element 2 fits into.

Furthermore, the top view shape of through hole 71 is rectangular or circular, and the lateral face of through hole 71 surrounds circuit element 2. It should be noted that there is a gap between the lateral face of through hole 71 and the lateral face of circuit element 2.

Electrodes of circuit element 2 disposed in through hole 71 are joined to second wire 50 in the same manner as in Embodiment 1 described above. In the present embodiment, through holes 71 are formed only at locations where circuit elements 2 are present. In other words, through holes 71 are formed only on portions (electrode portions) of second wires 50 on which circuit elements 2 are to be provided.

As described above, even in wiring board 1C according to the present embodiment, first insulating layer 20 and second insulating layer 30 are stacked above film 10 which is made of resin, first wires 40 are formed in first grooves 21 of first insulating layer 20, and second wires 50 are formed in second grooves 31 and openings 32 of second insulating layer 30. In addition, the top face of first wires 40 and the bottom face of second wires 50 are joined together.

With this configuration, wiring board 1C according to the present embodiment also achieves advantageous effects such as being able to reduce the proportion occupied by wiring when wiring board 1C is viewed from the top, and improve the transmittance of wiring board 1C.

In wiring board 1C according to the present embodiment, third insulating layer 70 is further formed on second insulating layer 30.

With this configuration, third insulating layer 70 functions as a protective layer, and thus the reliability of wiring board 1C improves.

Furthermore, in the present embodiment, through holes 71 are formed in third insulating layer 70 which is the uppermost layer of wiring board 1C. Through holes 71 are formed at element mounting portions in which circuit elements 2 are provided. Specifically, through holes 71 are formed, as recesses which circuit elements 2 fit into, in third insulating layer 70 which is the uppermost layer.

With this configuration, when circuit elements 2 are mounted onto wiring board 1C, circuit elements 2 readily fit into through holes 71. Accordingly, circuit elements 2 can be easily mounted at predetermined positions in wiring board 1C, and positional misalignment of circuit elements 2 during mounting can be reduced.

Furthermore, in the present embodiment, through holes 71 are formed only on portions (electrode portions) of second wires 50 on which circuit elements 2 are to be provided. Accordingly, corrosion of second wires 50 can be reduced.

It should be noted that although the lateral face of through hole 71 formed in third insulating layer 70 forms a perpendicular face with respect to the top face of third insulating layer 70 in wiring board 1C illustrated in FIG. 12, the present disclosure is not limited to this configuration. Specifically, as in wiring board 1D illustrated in FIG. 13, the lateral face of through hole 71 may be a sloped face that is sloped with respect to the top face of third insulating layer 70. Specifically, the sloped face of through hole 71 is preferably a tapered face having an aperture area that gradually increases following the depth direction of third insulating layer 70. With this configuration, circuit element 2 can more easily be mounted at a predetermined position in wiring board 1D.

Furthermore, as in wiring board 1E illustrated in FIG. 14, electrodes 80 which are joined to second wires 50 may be formed in through holes 72 of third insulating layer 70. In this case, since third insulating layer 70 is the uppermost layer of wiring board 1E, electrodes 80 are formed in the uppermost layer of wiring board 1E. Electrodes 80 are formed so as to be embedded in through holes 72, and have an exposed surface, for example. Accordingly, since second wires 50 are no longer exposed, corrosion of second wires 50 can be reduced. Circuit element 2 is connected to electrodes 80. Therefore, electrodes 80 are formed in a land-shape to correspond to the electrodes of circuit element 2. It should be noted that, as in wiring board 1E illustrated in FIG. 14, other electrodes are not present at locations other than through hole 72, and only electrodes 80 are exposed.

Furthermore, in FIG. 14, electrodes 80 formed in through hole 71 of third insulation layer 70 may be made of a material different from the material of second wires 50. With this configuration, the conductive material for electrodes 80 can be selected so as to improve the joinability between the electrodes of circuit element 2 and electrodes 80 which are the uppermost layer.

In this case, as in wiring board 1F illustrated in FIG. 15, electrodes 80F formed in through holes 72 of third insulating layer 70 may each include first electrode layer 81 and second electrode layer 82 stacked on top of first electrode layer 81. As an example, when second wires 50 to which electrodes 80F are to be joined are made of copper, first electrode layer 81 that is to be joined to second wires 50 is a nickel layer made of nickel, and second electrode layer 82 that is to be joined to first electrode layer 81 is a gold layer made of gold. With this configuration, it is possible to improve joinability when the electrodes of circuit elements 2 and electrodes 80F, which is the uppermost layer, are joined using solder, or the like. It should be noted that the nickel layer and the gold layer can be formed by plating.

### [Embodiment 4]

Next, wiring board 1G according to Embodiment 4 will be described with reference to FIG. 16. FIG. 16 is a cross-sectional view of wiring board 1G according to Embodiment 4. It should be noted that the cross-sectional view in FIG. 16 corresponds to the cross-sectional view of FIG. 3B in wiring board 1 of Embodiment 1 described above.

In wiring board 1 according to Embodiment 1 described above, the width of first wire 40 and the width of second wire 50 at the interface between first wire 40 and second wire 50 are the same, whereas, as illustrated in FIG. 16, in wiring board 1G according to the present embodiment, the width of first wire 40G and the width of second wire 50G at the interface between first wire 40G and second wire 50G are different.

In the present embodiment, the widths of first wire 40G and second wire 50G are constant in the thickness direction in the same manner as in Embodiment 1 described above. However, the width of first wire 40G and the width of second wire 50G are different not only at the interface between first wire 40 and second wire 50, the overall width of first wire 40G and the overall width of second wire 50G are also different.

In this case, as illustrated in FIG. 16, the width of second wire 50G located at the upper layer is preferably greater than the width of first wire 40G located in the lower layer. It should be noted that although, in the present embodiment, the width of first wire 40G is the same as the width of first wire 40 in Embodiment 1 described above, and the width of second wire 50G is made greater than the width of second wire 50 in Embodiment 1 described above, the present disclosure is not limited to this configuration.

As described above, in the same manner as in Embodiment 1 described above, even in wiring board 1G according to the present embodiment, first insulating layer 20 and second insulating layer 30 are stacked above film 10 which is made of resin, first wires 40G are formed in first grooves 21 of first insulating layer 20, and second wires 50G are formed in second grooves 31 and openings 32 of second insulating layer 30. In addition, the top face of first wires 40G and the bottom face of second wires 50G are joined together.

With this configuration, wiring board 1G according to the present embodiment also achieves the advantageous effects such as being able to reduce the proportion occupied by wires when wiring board 1G is viewed from the top, and improve the transmittance of wiring board 1G.

Furthermore, in the present embodiment, the width of first wire 40G and the width of second wire 50G are different at the interface between first wire 40G and second wire 50G.

With this configuration, even when misalignment occurs between the layers of first insulating layer 20 in which first wires 40G are formed and second insulating layer 30 in which second wires 50G are formed, the joined state between the top face of first wires 40G and the bottom face of second wires 50G formed in openings 32 can be ensured, and thus a change in the resistance at the joint (contact) between first wires 40G and second wires 50G can be reduced. In other words, resistance variation can be reduced.

Furthermore, in wiring board 1G according to the present embodiment, the width of second wires 50G located in the upper layer is greater than the width of first wires 40G located in the lower layer.

With this configuration, element connectability between second wire 50G and circuit element 2 can be improved. Specifically, even when misalignment of circuit element 2 occurs during mounting, the joined state between the electrodes of circuit element 2 and second wires 50G can be ensured.

### [Embodiment 5]

Next, wiring board 1H according to Embodiment 5 will be described with reference to FIG. 17 and FIG. 18. FIG. 17 is a top view of wiring board 1H according to Embodiment 5. FIG. 18 is a cross-sectional view of wiring board 1H taken along line XVIII-XVIII in FIG. 17. It should be noted that FIG. 17 and FIG. 18 illustrate a portion of the configuration of wiring board 1H.

As illustrated in FIG. 17 and FIG. 18, wiring board 1H according to the present embodiment includes lower insulating layer 90 disposed below first insulating layer 20 in addition to the configuration of wiring board 1 according to Embodiment 1 described above. Lower insulating layer 90 can be formed using the same material as that of first insulating layer 20.

Grooves 91 are formed in lower insulating layer 90. Grooves 91 can be formed using the same method as that for first grooves 21 of first insulating layer 20.

Conductive diverging wires 100 are formed in grooves 91 in lower insulating layer 90. Diverging wires 100 can be formed using the same conductive material as that of first wires 40 in Embodiment 1 described above. As an example, diverging wires 100 are copper wires made of copper.

First wire 40H according to the present embodiment is divided into first partial wire 401 and second partial wire 402. Specifically, first main wires 41H of first wires 40H are each divided into first partial wire 401 and second partial wire 402.

In addition to first grooves 21, openings 22 are formed in first insulating layer 20. Openings 22 of first insulating layer 20 can be formed using the same method as that for openings 32 of second insulating layer 30.

In the same manner as in Embodiment 1 described above, first wires 40H are formed in first grooves 21 of first insulating layer 20. Specifically, each of first partial wire 401 and second partial wire 402 is formed in first groove 21. In the present embodiment, a portion of first wire 40H is formed in opening 22 of first insulating layer 20. Specifically, first partial wire 401 of first wire 40H is formed in opening 22 of first insulating layer 20.

The bottom face of first wire 40H (first partial wire 401) formed in opening 22 of first insulating layer 20 and the top face of diverging wire 100 are joined together. In other words, the bottom face of first wires 40H formed in openings 22 is in contact with the top face of diverging wires 100. Therefore, first partial wires 401 of first wires 40H formed in openings 22 are contacts (vias), and first partial wires 401 and diverging wires 100 are connected via openings 22 (via holes). In this manner, first partial wires 401 of first wires 40H are connected, via openings 22 formed in first insulating layer 20, to diverging wires 100 formed in grooves 91 of lower insulating layer 90. In other words, diverging wires 100 function as first wires 40H. In this manner, in the present embodiment, first wire 40H has an area that diverges in the thickness direction, and has a two-storey structure due to diverging wire 100.

With this configuration current flowing through first wires 40H can be dispersed. Specifically, the current flowing through first wire 40H can be dispersed to the wire path composed of first partial wire 401 and diverging wire 100 and the wire path composed of second partial wire 402. Accordingly, since voltage drop in first wires 40H can be reduced, the voltage applied to each of the plurality of circuit elements 2 can be made uniform.

It should be noted that, aside from these elements, wiring board 1H according to the present embodiment has the same configuration as wiring board 1 according to Embodiment 1 described above.

Therefore, even in wiring board 1H according to the present embodiment, first insulating layer 20 and second insulating layer 30 are stacked above film 10, first wires 40H are formed in first grooves 21 of first insulating layer 20, and second wires 50 are formed in second grooves 31 and openings 32 of second insulating layer 30. In addition, the top face of first wires 40H and the bottom face of second wires 50 are joined together.

With this configuration, wiring board 1H according to the present embodiment also achieves the advantageous effects such as being able to reduce the proportion occupied by wires when wiring board 1H is viewed from the top, and improve the transmittance of wiring board 1H.

It should be noted that, as in wiring board 1I illustrated in FIG. 19 and FIG. 20, openings 22 of first insulating layer 20, which are the connections (contacts) between first partial wires 401 and diverging wires 100, may be disposed below second wiring 50. Accordingly, since the connections between first partial wires 401 and diverging wires 100 can be hidden by second wires 50, it is possible to have a good appearance even when first wires 40H are divided.

### [Embodiment 6]

Next, wiring board 1J according to Embodiment 6 will be described with reference to FIG. 21. FIG. 21 is a top view of wiring board 1J according to Embodiment 6. FIG. 21 illustrates the periphery of a portion of wiring board 1J. It should be noted that, in FIG. 21, circuit elements 2 have been omitted.

As illustrated in FIG. 21, in wiring board 1J according to the present embodiment, first external connection terminals 110 for supplying power to first wires 40 and second external connection terminals 120 for supplying power to second wire 50 are formed in the same wire layer.

A plurality of first external connection terminals 110 are formed to correspond to the plurality of first wires 40. A plurality of second external connection terminals 120 are formed to correspond to the plurality of second wires 50.

Wiring board 1J includes active region 3a in which the plurality of circuit elements 2 are arranged in a matrix and peripheral region 3b that surrounds active region 3a. Even in the present embodiment, circuit elements 2 are LED light sources and wiring board 1J is a display device, and thus active region 3a is a display region for displaying an image.

First external connection terminals 110 and second external connection terminals 120 are formed in peripheral region 3b. Specifically, first external connection terminals 110 are lead electrodes for leading first wires 40 out to peripheral region 3b, and second external connection terminals 120 are lead electrodes for leading second wires 50 out to peripheral region 3b.

As an external wiring components, a flexible wiring board is connected to first external connection terminals 110 and a flexible wiring board is connected to second external connection terminals 120. As a flexible wiring board, for example, it is possible to use a chip on film (COF) substrate in which a driver IC is mounted on a flexible substrate in which a plurality of wires are formed. One end portion of the flexible wiring board configured in the above-described manner is connected to first external connection terminals 110 or second external connection terminals 120 by anisotropic conductive film (AFC) pressure connection, for example.

Both of first external connection terminals 110 and second external connection terminals 120 are formed in the same layer as second wires 50. Specifically, like second wires 50, both of first external connection terminals 110 and second external connection terminals 120 are formed in second grooves 31 of second insulating layer 30 which is the uppermost layer of wiring board 1J.

In this case, first external connection terminals 110 that are connected to first wires 40 formed in first insulating layer 20 are connected to first wires 40 located in a lower layer via contacts 111 formed in first insulating layer 20.

Connections 111 are openings identical to openings 32 formed in second insulating layer 30 but are provided in peripheral region 3b. Specifically, openings 32 (contacts) for connecting first wires 40 and second wires 50 are provided inside active region 3a, whereas the openings (contacts 111) for connecting first wires 40 and first external connection terminals 110 are provided outside active region 3a.

It should be noted that second external connection terminals 120 connected to second wires 50 are a portion of second wires 50. In other words, the portions of second wires 50 that are lead out until peripheral region 3b are considered as second external connection terminals 120.

In this manner, in wiring board 1J according to the present embodiment, first external connection terminals 110 and second external connection terminals 120 are formed in the same wire layer, and thus connection of an external wiring component such as a flexible wiring board and first external connection terminals 110 or second external connection terminals 120 can be carried out easily compared to wiring board 1Y of Comparative Example 2 illustrated in FIG. 22.

It should be noted that, in wiring board 1Y of Comparative Example 2, first external connection terminals 110Y and second external connection terminals 120 are formed in different wire layers. Specifically, in wiring board 1Y of Comparative Example 2, first external connection terminals 110Y are formed in the same layer as first wires 40 and second external connection terminals 120 are formed in the same layer as second wires 50. For this reason, in wiring board 1Y of Comparative Example 2, openings are formed in first insulating layer 20 in order to expose first external connection terminals 110Y.

In addition, in the present embodiment, second insulating layer 30 into which first external connection terminals 110 and second external connection terminals 120 are embedded is the uppermost layer of wiring board 1J, and thus connection of an external wiring component such as a flexible wiring board and first external connection terminals 110 or second external connection terminals 120 can be carried out even more easily.

It should be noted that, in wiring board 1J according to the present embodiment, elements other than first external connection terminals 110 and second external connection terminals are the same as in wiring board 1 according to Embodiment 1 described above.

Therefore, even in wiring board 1J according to the present embodiment, first insulating layer 20 and second insulating layer 30 are stacked above film 10, first wires 40 are formed in first grooves 21 of first insulating layer 20, and second wires 50 are formed in second grooves 31 and openings 32 of second insulating layer 30. In addition, the top face of first wires 40 and the bottom face of second wires 50 are joined together.

With this configuration, wiring board 1J according to the present embodiment also achieves the advantageous effects such as being able to reduce the proportion occupied by wires when wiring board 1J is viewed from the top, and improve the transmittance of wiring board 1J.

### (Variations)

Although wiring boards according to the present disclosure have been described above based on exemplary embodiments, the present disclosure is not limited to Embodiments 1 to 6 described above.

For example, although the wiring boards according to Embodiments 1 to 6 described above are display devices in which, as circuit elements 2, LED light sources are arranged in a matrix, the present disclosure is not limited to this configuration. For example, the wiring boards according to Embodiments 1 to 6 described above may be used in a touch panel. In this case, the wiring board can be used as a touch sensor board in which a sensor electrode is provided in each of the first wires and the second wires. Furthermore, in this case, first external connection terminals 110 and second external connection terminals 120 in Embodiment 6 may function as extraction connection terminals for extracting, to the outside of the wiring board, sensor signals detected by sensor electrodes.

Furthermore, although it described that third insulating layer 70 is formed above second insulating layer 30 in the wiring board according to Embodiment 3 described above, and that lower insulating layer 90 is formed below first insulating layer 20 in the wiring board according to Embodiment 5 described above, the present disclosure is not limited to these configurations. For example, another insulating layer may be formed between first insulating layer 20 and second insulating layer 30. Specifically, another insulating layer may be further formed at least one of above first insulating layer 20, between first insulating layer 20 and second insulating layer 30, or above second insulating layer 30.

Furthermore, the technique of the present disclosure can also be used as a wiring board of an electronic device other than a display device or a touch panel.

For example, as in wiring board 1K illustrated FIG. 23, the technique of the present disclosure can be used as an antenna board. (a) in FIG. 23 is a top view of wiring board 1K, and (b) in FIG. 23 is a cross-sectional view taken along line B-B in (a). As illustrated in FIG. 23, wiring board 1K includes first wire 40K formed in first groove 21 of first insulating layer 20, and second wire 50K formed in opening 32 of second insulating layer 30 and first wire 40K and second wire 50K are joined via opening 32. In the present variation, first wire 40K and second wire 50K function as an antenna.

Furthermore, as in wiring board 1L illustrated in FIG. 24, the technique of the present disclosure can be used as a communication line board, (a) in FIG. 24 is a top view of wiring board 1L, and (b) in FIG. 24 is a cross-sectional view taken along line B-B in (a). As illustrated in FIG. 24, wiring board 1L includes first wire 40L formed in first groove 21 of first insulating layer 20 and second wire 50L formed in openings 32 of second insulating layer 30, and first wire 40L and second wire 50L are joined via openings 32 In the present variation, first wire 40L and second wire 50L function as a communication line.

It should be noted that, aside from the above, forms obtainable through various modifications to the foregoing embodiments that can be conceived by those skilled in the art as well as forms that can be realized from arbitrary combinations of elements and functions in the embodiments that do not depart from the essence of the present disclosure are included in the present disclosure.

### [Industrial Applicability]

A wiring board according to the present disclosure can be used in various electronic devices such as a display device or a touch panel.

### [Reference Signs List]

1, 1a, 1A, 1B, 1C, 1D, 1E, 1F, 1G, 1H, 1I, 1J, 1K, 1L wiring board
2 circuit element
3a active region
3b peripheral region
10 film
20 first insulating layer
20a first groove forming layer
21 first groove
22 opening
30 second insulating layer
30a second groove forming layer
31 second groove
31a first recess
32 opening
32a second recess
40, 40a, 40G, 40H, 40K, 40L first wire
41, 41H first main wire
42 first branch wire
50, 50B, 50G, 50K, 50L second wire
51 second main wire
52 second branch wire
53 contact wire
61, 62 black layer
61a black film
61b blackened film
70 third insulating layer
71, 72 through hole
80, 80F electrode
81 first electrode layer
82 second electrode layer
90 lower insulating layer
91 groove
100 diverging wire
110, 110Y first external connection terminal
111 contact component
120 second external connection terminal
401 first partial wire
402 second partial wire
510 first conductive layer
520 second conductive layer
521 lower conductive layer
522 upper conductive layer

## Claims

1. A wiring board comprising:
a film made of resin;
a first insulating layer located above the film and including a first groove;
a first wire provided in the first groove, the first wire being conductive;
a second insulating layer located above the first insulating layer and including a second groove and an opening, the opening being located above the first wire; and
a second wire provided in the second groove and the opening, the second wire being conductive, wherein
the first groove includes a first base face and first lateral faces that are continuously connected to the first base face,
in the first base face and the first lateral faces, the first insulating layer is made of a same material,
the second groove includes a second base face and second lateral faces that are continuously connected to the second base face,
in the second base face, the second lateral faces, and a lateral face of the opening, the second insulating layer is made of a same material, and
a top face of the first wire and a bottom face of the second wire that is provided in the opening are joined to each other.

2. The wiring board according to claim 1, wherein
when the wiring board is viewed from above, a region of the wiring board in which the first wire and the second wire are not provided has a transmittance of at least 80 percent.

3. The wiring board according to claim 1 or 2, comprising:
another insulating layer located at least one of below the first insulating layer, between the first insulating layer and the second insulating layer, or above the second insulating layer.

4. The wiring board according to any one of claims 1 to 3, wherein
at least one of the first wire or the second wire includes at least three faces, and
a black layer is provided on at least one of the at least three faces.

5. The wiring board according to any one of claims 1 to 4, wherein
a black layer is provided on all faces of at least one of the first wire or the second wire.

6. The wiring board according to any one of claims 1 to 5, wherein
at least two types of metal materials are used in all wires of the wiring board including the first wire and the second wire.

7. The wiring board according to claim 6, wherein
the first wire is made of a conductive material different from a conductive material of the second wire.

8. The wiring board according to claim 6, wherein
the second wire includes a first conductive layer and one or more second conductive layers, the one or more second conductive layers being made of a material different from a material of the first conductive layer.

9. The wiring board according to claim 8, wherein
the one or more second conductive layers include a nickel layer and a gold layer stacked onto the nickel layer.

10. The wiring board according to any one of claims 1 to 9, wherein
at least a portion of the second wire provided in the second groove has a thickness less than a thickness of the second insulating layer.

11. The wiring board according to any one of claims 1 to 10, wherein
at an interface between the first wire and the second wire, a width of the first wire and a width of the second wire are different.

12. The wiring board according to any one of claims 1 to 11, comprising:
a lower insulating layer located below the first insulating layer; and
a diverging wire provided in a groove in the lower insulating layer, the diverging wire being conductive, wherein
the first wire is connected to the diverging wire via an opening provided in the first insulating layer.

13. The wiring board according to claim 12, wherein
the opening provided in the first insulating layer is located below the second wire.

14. The wiring board according to any one of claims 1 to 13, comprising:
a third insulating layer located above the second insulating layer and including a through hole, wherein
the through hole is provided above the second wire.

15. The wiring board according to claim 14, wherein
a lateral face of the through hole is a sloped face.

16. The wiring board according to any one of claims 1 to 15, comprising:
an electrode provided in an uppermost layer of the wiring board, wherein
a circuit element is connected to the electrode.

17. The wiring board according to claim 16, wherein
the electrode provided in the uppermost layer is joined to the second wire and is made of a material different from a material of the second wire.

18. The wiring board according to any one of claims 1 to 17, comprising:
a first external connection terminal to which an external wiring component is to be connected, and a second external connection terminal to which an external wiring component is to be connected, wherein
the first external connection terminal is provided in the second insulating layer and connected to the first wire via a contact provided in the first insulating layer, and
the second external connection terminal is a portion of the second wire and is provided in the second insulating layer.

19. The wiring board according to claim 18, wherein
the second insulating layer is an uppermost layer of the wiring board.

20. The wiring board according to claim 18 or 19, wherein
the contact is located outside of an active region.
